# EUROPEAN PATENT APPLICATION

(11) **EP 0 554 618 A2**
(43) Date of publication of application: **11.08.1993**
(21) Application number: 92311124.9
(22) Date of filing: 07.12.1992
(51) Int. Cl.: G01R 11/24

(54) **Electricity meter**

(30) Priority: 07.12.1991 ID 1099
(71) Applicant: Pruwita, Tonny, Simpruk, Jakarta Selatan (ID)
(72) Inventor: Pruwita, Tonny, No. 29, Simpruk, Jakarta Selatan (ID); Chia-Chang Hu, Charles, Yun-Ho, Taipei (TW)
(74) Representative: Godsill, John Kenneth

(57) **Abstract**

An electricity meter for monitoring electricity drawn from an electricity supply 4 has analogue to digital conversion means (5) connected to the supply and arranged to provide digital signals, representative of the drawn electricity, to a central processing unit (1). The central processing unit is arranged to calculate from the digital signals the accumulated power consumed. A display (3) displays the power consumed and a keyboard (2) is provided for selecting other parameters, calculated by the central processing unit, for display.

## Description

This invention relates to electricity meters.

The conventional electric meter is a device for recording the number of its reading. Most conventional electric meters are of mechanic type. This type has some defects. For example, it is easy for a subscriber to steal power from it, or the employee of a power company may collaborate with a subscriber to steal power from it. This kind of management defects may cause a great loss to the power company. These defects can be described as follows:

### [1]. To steal power by biasing the electric meter:

The reason why a subscriber steals power by biasing the electric meter is that the conventional mechanic meter uses a magnetic dial scale to sense and register the graduation, when the meter is purposely or not purposely disposed in a slant position, it will result in a biased magnetic field. The biased magnetic field will decrease the rotation speed of the meter. Thus the sensed or registered graduation must be wrong so that the subscriber may pay much less than he should.

### [2]. To steal power by using magnetic iron:

The reason why a subscriber uses magnetic iron to steal electric power is that the magnetic field of conventional meter can easily be affected by a magnetic iron piece adhered on the case of the meter. According to the theory that two magnetic fields will expel with each other, by this way speed of the rotary dial will be slowed down.

### [3]. To steal power by connecting line to the opposite end:

The reason why a subscriber steals electric power by connecting line to the opposite end is that because the rotatory dial is controlled by magnetic-field induction, and when positive and negative polarities are exchanged and reversed to each other, mechanic rotary dial will rotate in opposite direction. Thus the gradulation of the meter will be decreased so that the subscriber may pay less money to the company.

### [4]. To steal power by jumper connection:

Most subscribers who stole power use this jumper connection method to steal. The method is to steal power by connecting another line which does not pass through the electric meter. In general, only the skilled electric workers or those people who know how to distribute electric power dare to use this method. It is very dangerous to use this method, so ordinary people dare not to do so. Because the line does not pass through the meter, flow of the current can not be sensed and measured by the meter, and no reading can be displayed. This method is the most difficult for a power company to deal with. Above all, if the subscriber obtains the collusion of its low-rank officials with bribes and these officials pretend that they know nothing about it, it will be much more difficult for the high-rank officials to solve this problem.

### [5]. To steal electric power by obtaining the collusion of officials with bribes:

The power company has to send out personnel to each subscriber's home to investigate the meter and take down the reading. Because this kind of personnel have worked in a given district for a long time, they are quite acquainted with the subscribers there. If a subscriber offers them bribes and asks them to take down false reading much lower than the real one purposely each time, and after a period of time they make a report that the meter does not work and change the old meter. In this way, the power company knows nothing about the fact. It is impossible for the high rank officials of the power company to control over the factor. It is not fair to other subscribers who do not offer the bribers to obtain the collusion. As a result, the company's income will become those unethical subscribers and low rank officials' income.

According to a first aspect of the invention there is provided an electricity meter for monitoring electricity drawn from an electricity supply, the meter comprising analogue to digital conversion means for connection to the supply and arranged to provide digital signals representative of supply voltage and current to a central processing unit, the central processing unit being arranged to calculate from the digital signals at least the accumulated power consumed from the supply.

According to a second aspect of the invention there is provided an electricity meter, comprising hardware and software, the meter being arranged to feed voltage and current present on a power line through a distribution voltage/distribution current circuit to an analog/digital converter arranged to convert the voltage and current into digital signals for use by a central processing unit, the central processing unit being arranged to calculate information including alternating voltage, alternating current, power factor, active power, and consumed power, the meter further comprising display means for displaying the information and a display keyboard for selecting information to be displayed.

It will thus be apparent that embodiments of the invention may overcome the defects of the conventional electric meter by providlng a micro computer intelligent sensor meter which uses an electronic sensor to process the reading and calculate it correctly in accordance with the formular of a micro processor. It does not use the magnetic induction and will not have an error of sensor resulted from bad or biased disposition.

Embodiments of the invention may also provide a micro computer intelligent sensor meter which has no magnetic induction and which will not be affected or interfered by a magnetic iron so that it is possible for a subscriber to steal electric power.

Embodiments may further provide a micro computer intelligent sensor meter which will not be interfered by magnetic field. Whether it is positively connected or negatlvely connected, under the electronic alternating flow, the sensor device will normally and correctly sense and register. In the flow of alternating current, electronic sensor and monitor do not change, but remains the same. This may prevent the electric power from being stolen by negative connection.

Embodiments may also provide a micro computer intelligent sensor meter which can use a computer time-shared network control over the main power company, transformer stations, and all subscribers. All transformer stations also use large computers which are series-parallel connected to all subscribers. The total reading sensed and measured by all transformer stations minus the fixed consumptive loss rate will be equivalent to the total reading of all subscribers.

Subscribers' meters may be controlled by a carrier transmit converter system which can obtain the reading of each subscriber's meter at a given time and can transmit a series of digital signals to transformer stations through carrier detect. The software of transformer station's computer meter can receive such digital signals and can check these signals with the total reading. If abnormal situations are found, signals can be transmitted back to the main power company's large-size computer through time-shared network. Then the large-size computer can send out the abnormal signals and display their addresses in different district. Then the company's high-rank officials may send inspectors and investigators to the district of abnormal situation. They may secretly insert a meter in the junction point on outside lines to detect the suspicious subscribers and by the method of comparison find out the subscriber who steals the electric power. Inspectors are to be sent to different districts each time so that they will not collude with subscribers. If the company can offer a big prize for those inspectors who catch the subscriber stealing electric power, the collusion between low-rank officials and subscribers can be completely avoided.

Embodiments may also provide a micro computer intelligent sensor meter for which the company can dispose a carrier send/receive control system in each subscriber district. The company needs not to send out register personnel to take down the reading of each subscriber's meter. This can overcome the trouble caused by the fact that subscribers are not at home and can avoid the waste of manpower and material resource. Each month, when registers drive a car with the portable computer, carrier send/receive system, and mini ink-spraying printer and transmit carrier commanding signals, the remote controlled carrier control system will send out each subscriber's reading, which will be calculated by the portable computer's software and be exchange to a remittance. The mini printer quickly prints out the payment invoice. The invoice can be mailed or thrown into the letter box of each subscriber. After the registers come back to the power company, they can put the portable computer's information into the large-size computer for processing. The large-size computer can control the situation of collecting payment by connecting, gaining, and comparing each collect remittance from each collect units. If a subscriber does not receive the payment notice, mail it to him. If he does not pay the remittance, the company can use the time shared network to send out signals of a cut-off for the electric power and can send instruction to subscriber's meter through network of each level.

A circuit break protection device may be provided to execute the instruction of cutting off the power supply. After it cuts off the power, it will not restore the power until the subscriber pay the remittance. It can do this correctly and quickly. It is very convenient to the subscriber because he need not wait for the company's repairman to restore the power for a long time. Above all, this will make the management of register and recipient more efficient. It may reduce personnel cost and solve the problem of stealing electric power by offering bribes. It is really the most fair and reasonable management proposal.

An electricity meter according to an embodiment of the present invention may comprise means for receiving outside signals transmitted through radio waves and can identify whether codes of the signals are the same as its own code or not, if the codes are the same, they will be managed together with said informations and then be sent back through radio waves to the outsider who transmitted the signals, so that transmitting frequency can be protected from being decoded and so that the informations can be protected from being altered with an evil intent.

For a better understanding of the invention and to show how the same may be carried into effect, reference will now be made, by way of example, to the accompanying drawings, wherein:

FIG 1 is a view of the structural hardware of the micro computer sensor meter according to an embodiment of this invention.

FIG 2 is a view of the flowsheet of the micro computer sensor meter according to an embodiment of this invention.

The micro computer sensor meter consists of hardware and software, wherein hardware comprises microprocessor 1, keyboard 2, and liquid crystal display (LCD) 3. The microprocessor 1 is composed of central processing unit (CPU), read only memory, random access memory, timer, LCD control circuit, input/output port, and serial communication interface.

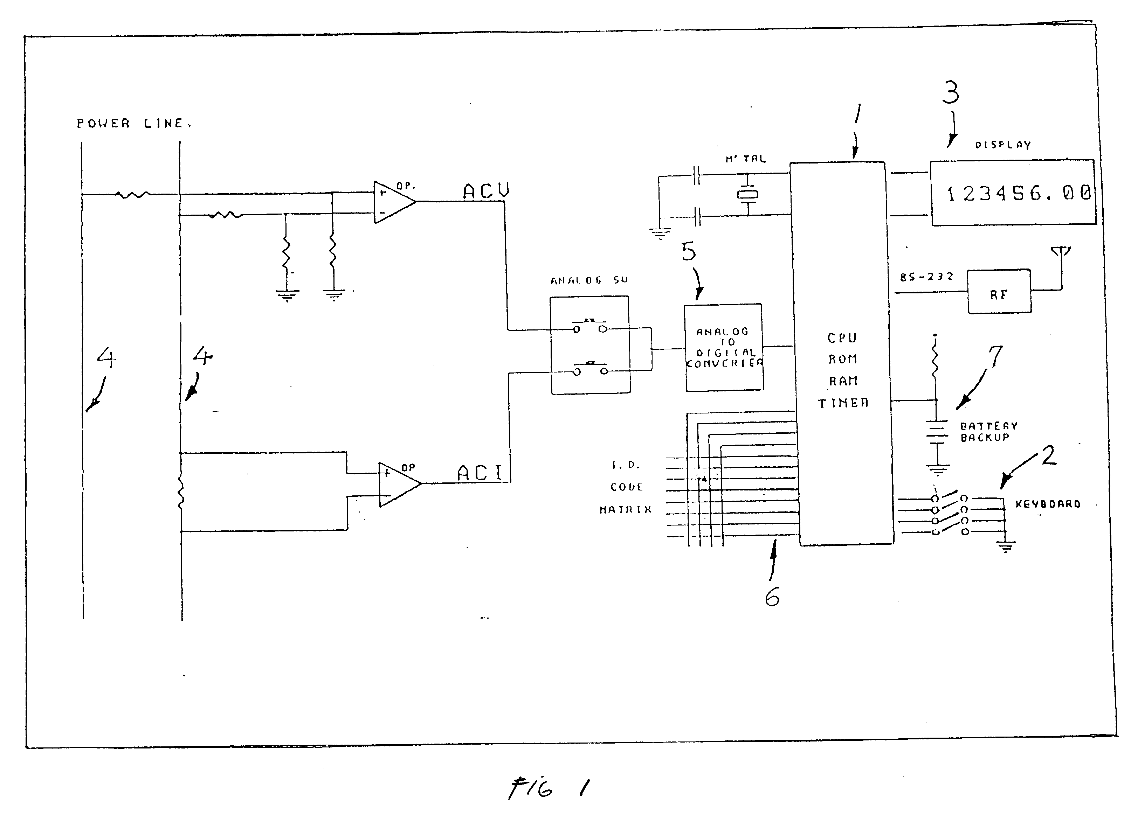

The function of the hardwrare is as follows: On power line 4, voltage and current pass through distribution voltage/distribution current circuit into analog/digital converter 5 and are converted into digital signals for processing and calculating in CPU. The calculated informations will be displayed on LCD 3. Because the microprocessor 1 has LCD control circuit in it, the display circuit is very simple. The contents of the display will be ACV, ACI, COS@ and KWH. Any item of these informations can be selected out by keyboard 2 to be investigated. Besides, each number of the electric meter must be the only one, no other two meter can be the same number, so there is an ID code matrix 6 in FIG 1 to identify the number. CPU will read the matrix to know its own number. When an outsider transmits and call through radio wave, all meters will receive the signals. And then CPU in the meter will compare and make an analog for the transmitted signals and identify them whether they are the same as its own or not. If they are the same as its own, it will process the information and then transmit them back to the transmitter. In addition, to prevent the informations from missing when there is no power, a recharging cell 7 is disposed in the electric meter to preserve the informations.

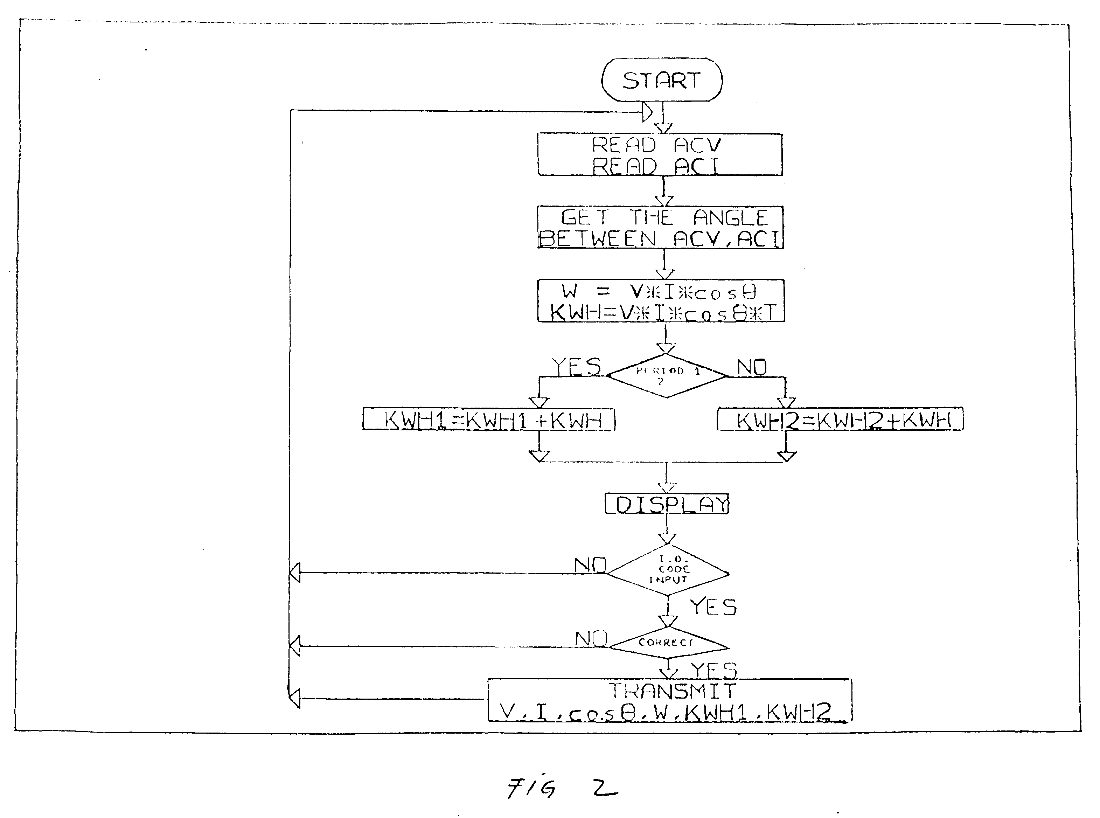

As shown in FIG 2, a flowsheet of the software can be illustrated as follows:

The electric meter according to this invention is to sense and detect on the power line the value of alternating voltage and alternating current, and to obtain angle @ of the phase difference between voltage and current. When these three data multiplicate with each other, the active power passed through the power line will be W = W x I x COS @ : Active power W multiplicates T (time) = the reading of the consumed power during the period; that is, KWH = V x I x COS @ x T = W x T.

Because of the different time, supply of electric power has high peak and low. peak, so this meter can also add the reading of consumed electric power to the corresponding reading according to the different periods. In the flowsheet, we can see the two items KWH1, KWH2, and these informations will be displayed on the screen.

The microprocessor has a subsidiary serial communication interface, so the program is constantly monitoring whether there are informations input into the serial communication port or not. If the input informations are transmitted codes, the program will immediately indentify them and compare them with its own ID code to see whether they are the same or not. If they are the same, it will processs the informations and then transmit them back to the transmitter. If they are not the same, it will go back to detect the information on the power line.

The functions of the softwrare are as follows:
1. The situation of electric power consumed by the subscriber is stored in the inner memory which can read and record informations of each day or each month, and which can be controled by outside instructions to store the informations.
2. In general, the meter only displays the total consumed reading of that very month, but when the keyboard is pressed down, it will display in turn the total consumed reading, peak power reading of that very month, off-peak power reading of that factor, active power, time, and finally back to the total consumed reading of that very month.
3. All these informations can be transmitted to outside through radio wave. Each meter has different ID code, when outside CPU (including transmitter, computer, and transmit station) transmits out the ID code, all electric meter in the effective range can receive the signals and then the microprocessor will identify such ID code to see whether it is his own or not. If it is not its own, the microprocessor will just leave it away. If it is its own, the microprocessor will transmit the related information back to the receiving CPU through radio wave.
4. A timer is disposed in the meter, which can be designed to have two periods. It will record the reading of electric power consumed by the subscriber according to the high peak and low peak of consumed power demanded. On that day for accounts settlement in that very month, the electric reading of different periods will be taken out for calculating the power rate.

As mentioned above, when compared with the conventional mechanical electric meter embodiments of the invention may provide the following advantages.
1. The electric meter itself consumes very little power.
2. No meter base error: In calculating power rate, so many troubles can be avoided, because the time for the system to investigate the meters is always the same, and the reading of the main meter is equivalent to the total reading of all branch meters because the power consumed in the main meter and the branch meter are all calculated in the power rate.
3. It can automatically check the meters (through communication system).
4. It can automatically limit the consumption of the electric power: It can set a standard of penalty from outside, when subscriber uses the electric power over the power supply standard listed in the contract, the meter will automatically register in the penalty process. The penalty rate can be set from outside.
5. After a leakage sensor is added to the meter, the meter can automatically cut off the power source if a short circuit happened. This can guard against fire disaster. The meter can also connect with leakage coil to cut off power source automatically. This can also guard a person against getting an electric shock. If a leakage protection device (tele-communication current sensor) is disposed on the meter, it can identify the situation of a person who gets an electric shock and then make an judgement to cut off the power source.
6. It can prevent electric power from being stolen by subscribers or those who obtain the collusion of officials with bribes. (Other methods of stealing power are mentioned above).

In addition, embodiments of the invention can improve the power engineering management. It can be described as follows:
1. Management of transformer station: At present, in the transformer station, any person who is on duty has to take a record for the situation of consumed electric power on a line every sixty minutes. Because man made error and recording time are not consistent, the data presented by all transformer stations can not be added up. The system of this invention can solve the problem mentioned above. By means of management of the computers in a non-attended transformer station, the situation of electric power consumption can be understood at a proper time, and the control over the electric power consumption in time can be practiced and operated.
2. Remote control over electric power load: if the subscriber consumes electric power which is more than he should consume or which is over loaded, or if he refuses to pay the power bill, the power company can cut off the power source or can calculate the penalty by remote control so as to effectively manage and control over the subscribers in each district. When power company can not supply enough electric power, the remote control can still effectively control over the supply and limits for each district fairly and reasonably. (after the power break device is disposed on the electric meter, the power break signals and informations can be processed through system network).
3. Balance of electric power: Because the time to investigate subscribers' meters can be consistent in this way, the situation of subscriber's power consumption can be precisely calculated so that the periods and districts of different power rate can be reasonably drawn up and set. In this way, the electric power can be kept in balance; that is, the peak is cut to fill the valley.

## Claims

1. An electricity meter for monitoring electricity drawn from an electricity supply, the meter comprising analogue to digital conversion means (5) for connection to the supply and arranged to provide digital signals representative of supply voltage and current to a central processing unit (1), the central processing unit being arranged to calculate from the digital signals at least the accumulated power consumed from the supply.

2. An electricity meter, comprising hardware and software, the meter being arranged to feed voltage and current present on a power line through a distribution voltage/distribution current circuit to an analog/digital converter (5) arranged to convert the voltage and current into digital signals for use by a central processing unit (1), the central processing unit being arranged to calculate information including alternating voltage, alternating current, power factor, active power, and consumed power, the meter further comprising display means (3) for displaying the information and a display keyboard (2) for selecting information to be displayed.

3. An electricity meter according to claim 1 or 2 wherein said meter is arranged to receive outside signals transmitted by radio waves and to identify signal codes present on the signals as its own code whereupon, if the codes are the same, they will be added to said information and the sum sent back via radio waves, so that retransmitted signals can be protected from being decoded and so that the information can be protected from being altered with a dishonest intent.

4. An electricity meter according to claim 1, 2 or 3 comprising a timer arranged to designate at least two periods in a day corresponding to peak and off peak charge bands, the meter being arranged to calculate separately the power consumed during the peak and off-peak charge bands.

5. An electricity meter according to any one of the preceding claims wherein a rechargeable cell (7) is disposed so as to preserve the information when there is no power.

6. An electricity meter according to claim 2 or to any one of claims 3 to 5 when appended to claim 2, wherein in normal use the meter only displays the total reading of consumed power, each of the peak power, off-peak power, alternating voltage, alternating current, power factor, active power and time being selectively displayable by means of the keyboard.

7. An electricity meter according to claim 2 or to any one of claims 3 to 6 when appended to claim 2, wherein the display means (3) is a liquid crystal display.
